# EUROPEAN PATENT APPLICATION

(11) **EP 2 840 618 A1**
(43) Date of publication of application: **25.02.2015**
(21) Application number: 13777801.5
(22) Date of filing: 16.04.2013
(51) Int. Cl.: H01L 33/20, H01L 33/22

(54) **METHOD FOR FABRICATING NANOPATTERNED SUBSTRATE FOR HIGH-EFFICIENCY NITRIDE-BASED LIGHT-EMITTING DIODE**

(30) Priority: 18.04.2012 KR 20120040150
(71) Applicant: Hunetplus Co., Ltd., Nonsan-si, Chungcheongnam-do 320-920 (KR)
(72) Inventor: CHA, Hyuk-Jin, Asan-si Chungcheongnam-do 336-744 (KR); LEE, Heon, Seoul 137-840 (KR); CHOI, Eun-Seo, Ansan-si Gyeonggi-do 426-182 (KR)
(74) Representative: Zardi, Marco
(86) International application number: PCT/KR2013/003186
(87) International publication number: WO 2013/157816

(57) **Abstract**

Provided is a method of manufacturing a nitride-based light emitting diode. According to the method, a substrate having a nano to micron sized pattern including a bottom section and a convex section, wherein a lower end diameter of the convex section is 0.1 to 3 times a light emitting wavelength of the light emitting diode, and a buffer layer formed on the substrate and formed as a GaN layer are manufactured. According to the method of manufacturing the nitride-based light emitting diode, light extraction is significantly improved, and the nano to micron sized pattern, economically formed.

## Description

### [Technical Field]

The present invention is provided to economically manufacture a nano to micron sized pattern on a substrate formed of sapphire monocrystal, quartz, silicon, or the like, using a nano print or nano imprint process, and form gallium nitride or the like thereon to provide a substrate for a nitride-based light emitting diode having reduced crystal defects, thus significantly increasing performance of the light emitting diode.

### [Background Art]

A light emitting diode is receiving attention as a light source for future lighting and widely used as a light source in various fields at present due to a long lifespan, small power consumption, and environment-friendliness in comparison with lighting fixtures such as conventional fluorescent lamp, incandescent lamp, and so on. In particular, since the nitride-based light emitting diode having a large bandgap has an advantage capable of emitting light of a region from green to blue and a region of near ultraviolet rays, application fields such as LCDs and mobile phone backlights, lightings for automobiles, traffic lights, general lightings, and so on, are being widely enlarged. However, performance of the nitride-based light emitting diode is not being sufficiently improved to satisfy such needs.

The performance of the light emitting diode is generally determined based on internal quantum efficiency according to how many photons are generated by injected (injection) electrons and light extraction efficiency according to how many photons can be emitted to an outside of a light emitting diode device.

In recent times, while the internal photon efficiency of the nitride-based light emitting diode has been largely improved due to development of the epitaxial growth technique, the light extraction efficiency is very low in comparison with the internal photon efficiency. When light generated in a multi quantum well (MQW) region, which is an active layer (a light emitting layer) of the light emitting diode, is emitted, total reflection is generated at a boundary between the light emitting diode device, external air, and an external sealing material such as epoxy, sapphire substrate, or the like. Since GaN has a refractive index of about 2.5, which is relatively larger than those of air (nₐᵢᵣ=1), epoxy (n_{epoxy}=1.5), and sapphire (n_{sap.}=1.77), critical angle regions in which the light generated in the MQW can exit to the outside of the device are θ_{GaN/air}=23°, θ_{GaN/epoxy}=37°, and θ_{GaN/sap.}=45°, which are very limited. Accordingly, the light departing from the critical angle range and entering in a direction toward the outside of the device cannot advance to the outside but is totally reflected until the light is absorbed in the device, and thus, the light extraction efficiency is merely several percent(%), which is very low. In addition, this causes problems leading to generation of heat in/of the device.

In order to overcome the limitation of the nitride-based light emitting diode, a research has been attempted for effectively reducing total reflection through diffused reflection of light by inserting a pattern into a p-GaN layer or a transparent electrode layer of a surface of the device. In particular, it is known that, when a sub-micron photonic crystal pattern in which patterns having a uniform size are regularly and densely arranged is introduced in a light emitting diode manufacturing process, the light extraction efficiency is largely increased. However, in consideration of formation of a p-type electrode after patterning, a manufacturing process of the light emitting diode such as a packaging process or the like and production yield, it is difficult to actually commercialize the patterning process of the p-GaN layer and the transparent electrode layer. Alternatively, when the epitaxial layer is grown on a patterned sapphire substrate (PSS), similarly, the light extraction efficiency may be effectively improved due to the diffused reflection effect of the light. In the case of the PSS, essentially, the technique developed to reduce a treading dislocation density due to lattice mismatch between the sapphire substrate and the GaN epitaxial layer and increase the internal photon efficiency, or the light extraction efficiency may also be significantly improved, and may be applied to the manufacturing process of the light emitting diode. Currently, in manufacturing companies of the light emitting diodes in domestic and foreign countries, products to which the PSS are applied are in a mass production stage.

### [DETAILED DESCRIPTION]

### [Technical Problem]

Currently, the patterned sapphire substrate (PSS) is mainly manufactured through a photolithography process and a dry and wet etching process, and specification of most of the patterns is about several microns. An extent in improvement of the light extraction efficiency of the light emitting diode due to the diffused reflection of the light is largely varied according to size, shape, cycle, or the like, of the patterns. It is known that, when a nano photonic crystal pattern is applied to a light emitting region of the light emitting diode, light extraction is largely increased. Accordingly, a diameter and cycle of the micro pattern of a conventionally commercialized PSS should be reduced to a nano grade to improve the efficiency of the light emitting device, and a shape of the pattern should (also) be optimized.

Since the photolithography, which is a patterning technique used for manufacturing of the PSS, is expensive and application of the nano to micron sized pattern increases manufacturing cost of products and significantly decreases economic feasibility, the light extraction efficiency cannot be easily improved through the conventional method and the PSS. Accordingly, in order to additionally improve efficiency of the light emitting diode, instead of the expensive photolithography, a patterning technique capable of economically manufacturing the nano to micron sized pattern is needed.

### [Solution to Problem]

In order to accomplish the above-mentioned aspects, a method of manufacturing a nitride-based light emitting diode, according to an embodiment of the present invention, includes a first step of forming a thin corrosion-proof resist film on one surface of a substrate or one surface of a nano mold; a second step of positioning and pressing the substrate or the nano mold to face the thin corrosion-proof resist film and forming the thin corrosion-proof resist film having the nano to micron sized pattern on the substrate; a third step of etching the substrate on which the nano to micron sized pattern is formed; and a fourth step of annealing the etched substrate.

The nano to micron sized pattern may include a bottom section and a convex section, and a lower end diameter of the convex section may be 0.1 to 3 times a light emitting wavelength of the light emitting diode.

The bottom section and the convex section of the nano to micron sized pattern may be alternately formed, a distance between a first convex section and a second convex section, which is adjacent to the first convex section, may be 0.2 to 6 times the light emitting wavelength of the light emitting diode, and a cycle of the second convex section adjacent to the first convex section may be 0.2 to 6 times the light emitting wavelength of the light emitting diode.

The nano to micron sized pattern may repeatedly include any one selected from the group consisting of a hemispherical shape, a triangular pyramidal shape, a quadrangular pyramidal shape, a hexagonal pyramidal shape, a conical shape and a semi- or cut-spherical shape.

The method of manufacturing the nitride-based light emitting diode may further include a fifth step of further forming a buffer layer formed as a GaN layer on the annealed substrate after the fourth step, thereby improving the light extraction efficiency of the light emitting diode.

The substrate may be any one selected from the group consisting of a sapphire substrate, a silicon substrate, and a quartz substrate, and may include any one selected from the group consisting of Al₂O₃, SiC, Si, SiO₂, quartz, AlN, GaN, Si₃N₄, and MgO.

A nitride-based light emitting diode according to another embodiment of the present invention includes a substrate manufactured by a method of manufacturing the nitride-based light emitting diode. The substrate for the light emitting diode includes a substrate, a convex section formed on one surface of the substrate, and a bottom section on which the convex section is not formed, wherein the convex section may be repeatedly formed, a lower end diameter of the convex section may be 0.1 to 3 times a light emitting wavelength of the light emitting diode, and a formation cycle of a first convex section and a second convex section, which is adjacent to the first convex section, may be 0.2 to 6 times the light emitting wavelength of the light emitting diode.

### [Advantageous Effects of Invention]

In the present invention, as a diameter and a cycle of a pattern of a substrate for a light emitting diode are reduced to a nano grade, internal photon efficiency and light manufacturing a nano to micron sized pattern on a substrate using a nano print (or imprint) lithography technique, which is an economic and non-optical patterning technique, is presented. Since the nano print (or imprint) technique enables transfer or formation of a pattern onto a large area through an economic and simple process without necessity of expensive exposure equipment, production yield may be increased. In particular, since the patterning for the light emitting diode does not require precise alignment, the nano print (or imprint) process, which is a direct pattern transfer method, may be appropriately applied, and a sub-micron pattern may be easily formed. Accordingly, in comparison with the conventional photolithography process for manufacturing the PSS, when the nano print (or imprint) technique is applied to the PSS process, performance of the product may be further improved and economic feasibility may be accomplished, and mass production of high efficiency PSS light emitting diode becomes possible. Furthermore, when a material such as gallium nitride is formed thereon, the material may be formed to significantly reduce crystal defects. Thus, a probability of light emitted in a light emitting device being scattered and (thereby) reducing internal total extraction efficiency of the light emitting diode is significantly minimized; light emitting performance of the device may be noticeably improved.

Further, the present invention may be applied to a top emission light emitting diode, a flip-chip light emitting diode, and a vertical light emitting diode, which are conventional light emitting diodes.

### [BRIEF DESCRIPTION OF DRAWINGS]

FIG. 1 is a schematic view showing a method of manufacturing a nitride-based light emitting diode according to an embodiment of the present invention.
FIG. 2 is a conceptual view showing examples of various patterns that may be applied to embodiments of the present invention.
FIG. 3 is a conceptual view of a light emitting diode manufactured according to an embodiment of the present invention.

### [Reference Signs List]

A: Lower end diameter of convex section
B: Formation cycle of first convex section and second convex section

### [Description of Embodiments]

Hereinafter, embodiments of the present invention will be described with reference to the accompanying drawings for those skilled in the art. However, the present invention is not limited to the embodiments but may be implemented in various different ways. Like elements are designated by like reference numerals throughout the description.

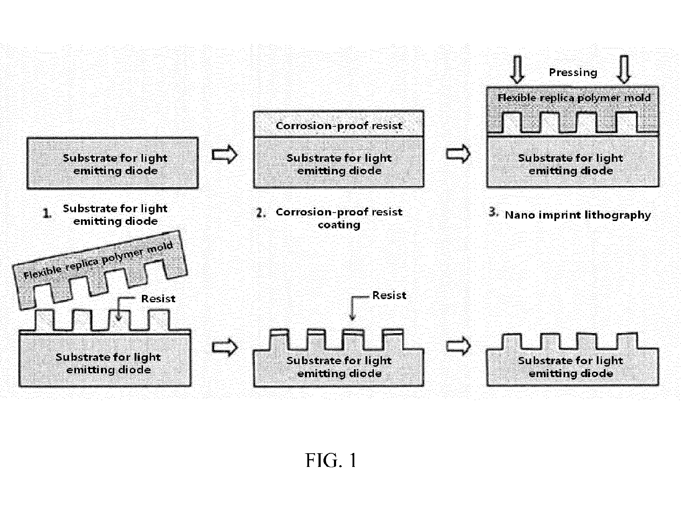

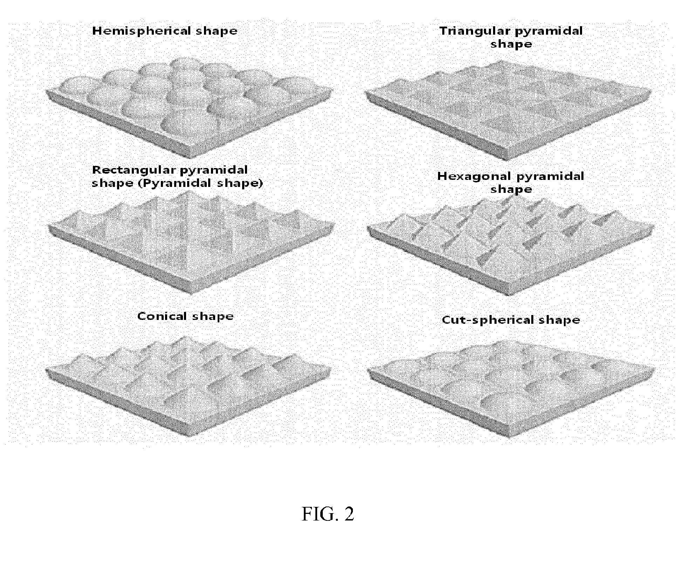

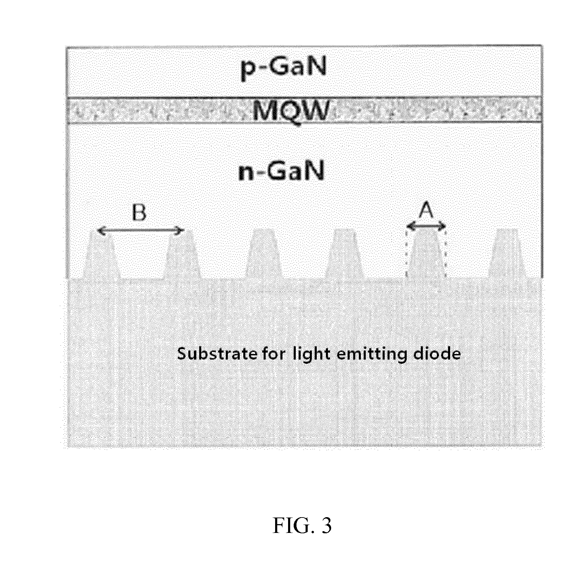

FIG. 1 is a schematic view showing a method of manufacturing a nitride-based light emitting diode according to an embodiment of the present invention. FIG. 2 is a conceptual view showing examples of various patterns that may be applied to (various) embodiments of the present invention. FIG. 3 is a conceptual view of a light emitting diode manufactured according to the embodiment(s) of the present invention. The method of manufacturing the nitride-based light emitting diode according to the embodiment of the present invention includes a first step of forming thin a corrosion-proof resist film on one surface of a substrate or one surface of a nano mold, a second step of positioning and pressing the substrate or the nano mold to face the thin corrosion-proof resist film and forming the thin corrosion-proof resist film having a nano to micron sized pattern on the substrate, a third step of etching the substrate on which the nano to micron sized pattern is formed, and a fourth step of annealing the etched substrate.

The substrate may be a silicon substrate or a quartz substrate as well as a sapphire substrate used as an LED substrate. The substrate may include any one selected from the group consisting of Al₂O₃, SiC, Si, SiO₂, quartz, AlN, GaN, Si₃N₄ and MgO.

The thin corrosion-proof resist film may be a thin film including a silicon oxide sol layer. The silicon oxide sol layer may be formed by manufacturing a silicon oxide sol and then spin coating the silicon oxide sol on the substrate or the nano mold, and the silicon oxide sol may be manufactured by melting tetraethyl orthosilicate (TEOS) in a solvent, and the solvent applied thereto may be an organic solvent such as ethanol, methanol, dimethylformamide (DMF), and so on, but it is not limited thereto.

When the thin corrosion-proof resist film is formed on the one surface of the substrate, the nano to micron sized pattern may be formed in a nano imprint method of positioning and pressing the nano mold to face the corrosion-proof resist thin film, and forming the corrosion-proof resist thin film having the nano to micron sized pattern on the substrate in the second step.

The corrosion-proof resist thin film may be formed on the one surface of the nano mold, and the nano to micron sized pattern may be formed in a nano printing method of positioning and pressing the nano mold to face the substrate and forming the corrosion-proof resist thin film having the nano to micron sized pattern on the substrate in the second step. When the corrosion-proof resist thin film is formed on the one surface of the nano mold, a curing process may be further included.

The mold of the nano to micron sized pattern may be a flexible replica polymer mold, and may be formed of polymer material such as PDMS, h-PDMS, PVC, and so on. The nano to micron sized pattern of the mold may include a bottom section and a convex section formed in the thin corrosion-proof resist film, and may be applied as long as a lower end diameter A of the convex section formed in the substrate forms the nano to micron sized pattern 0.1 to 3 times of a light emitting wavelength of the light emitting diode. As shown in FIG. 3, the lower end diameter A denotes a diameter of a cross-section of the convex section on the surface at which the convex section comes in contact with the bottom section.

In the second step, the pressing may be performed at 1 to 20 atm (unit of pressure), and a temperature upon the pressing may be 70 to 250 °C.

The nano to micron sized pattern printed or imprinted on the substrate through the third step includes a bottom section and a convex section, and a lower end diameter of the convex section is 0.1 to 3 times the light emitting wavelength of the light emitting diode. That is, provided that the light emitting wavelength of the light emitting diode is λ, the lower end diameter of the convex section may be 0.1λ to 3λ, and the light emitting wavelength of the light emitting diode may be applied according to a wavelength of light, which is to be provided to the light emitting diode. When the lower end diameter of the convex section is within the range, the light emitting efficiency of the light emitting diode may be significantly increased.

The bottom section and the convex section of the nano to micron sized pattern may be alternately formed. A distance between a first convex section and a second convex section, which is adjacent to the first convex section, may be 0.2 to 6 times the light emitting wavelength of the light emitting diode. And provided that the light emitting wavelength of the light emitting diode is λ, a formation cycle B of the first convex section and the second convex section adjacent to the first convex section may be 0.2λ to 6λ. (As shown in FIG. 3, the formation cycle B denotes a formation cycle of the first convex section and the second convex section.) When the cycle of the nano to micron sized pattern is within the range, the light emitting efficiency of the light emitting diode may be significantly increased.

As shown in FIG. 2, the nano to micron sized pattern may be formed by repeating any one selected from the group consisting of a hemispherical shape, a triangular pyramidal shape, a quadrangular pyramidal shape, a hexagonal pyramidal shape, a conical shape, and a cut-spherical shape. Since the patterns use the nano printing or nano imprinting, desired shape of the patterns may be manufactured and applied according to a master template.

When the nano to micron sized patterns are formed in a three-dimensional shape having regularity, lattice mismatch of the GaN layer formed on the substrate may be reduced, and thus, the treading dislocation density may be reduced to increase the internal photon efficiency. In addition, while the light extraction efficiency may be slightly improved according to shapes of the patterns, low light extraction efficiency may (thereby) be improved by the diffused reflection in the diode.

The etching in the third step may be a method of etching the substrate, for example, a dry etching, wet etching, ion etching method, or the like. When a remaining layer (or residue) is remained in the thin corrosion-proof resist thin film after the etching, the remaining layer may be removed before a fifth step (to be described later).

The annealing in the fourth step may be performed at a temperature of 300 to 1,000 °C, and a patterned sapphire substrate (PPS) of the nano to micron sized pattern may be formed on the substrate through the annealing.

The method of manufacturing the nitride-based light emitting diode may include a fifth step of further forming a buffer layer formed as a GaN layer on the annealed substrate after the fourth step. As the buffer layer is formed on the substrate in which GaN is formed in a nano to micron sized pattern, the lattice mismatch generated upon formation of the GaN on the substrate may be reduced in general cases and the lattice mismatch may be more precisely reduced with the nano to micron sized pattern. In addition, since the pattern may have a uniform size and cycle according to the wavelength of the light emitting diode, the diffused reflection that lowers the light extraction efficiency may be minimized, and the light extraction efficiency of the light emitting diode may be improved.

Further, while a patternable size is limited to a micron unit in the conventional photolithography (process), the nano printing or nano imprinting method of the present invention may be applied to precisely form the nano to micron sized pattern on the substrate, and simultaneously, different from the conventional photolithography process, a process of manufacturing the substrate for a light emitting diode and the light emitting diode including the same may be simplified.

A light emitting diode according to another embodiment of the present invention includes a substrate manufactured by the method of manufacturing the nitride-based light emitting diode. The substrate for the light emitting diode includes a substrate, a convex section formed on one surface of the substrate, and a bottom section in which the convex section is not formed. The convex section may be repeatedly formed, the lower end diameter of the convex section may be 0.1 to 3 times the light emitting wavelength of light emitting diode, and a formation cycle of the first convex section and the second convex section adjacent to the first convex section may be 0.2 to 6 times the light emitting wavelength of the light emitting diode.

FIG. 3 is a conceptual view of a light emitting diode of the present invention. Referring to FIG. 3, through the above-mentioned method, a substrate for a light emitting diode on which a nano to micron sized pattern is formed, and an n-GaN layer, an MQW layer, and a p-GaN layer, which are formed thereon, are sequentially formed. The n-GaN layer may further include a buffer layer formed of GaN at a lower end thereof, and the buffer layer may reduce lattice mismatch to improve light extraction efficiency.

In addition, the light emitting diode including the substrate for the light emitting diode may reduce residual stress after formation of a GaN film, which includes the buffer layer, and prevent bending thereof even when a diameter of the substrate is increased due to a regular nano to micron sized pattern and the buffer layer formed thereon of GaN.

The light emitting diode may be a top emission light emitting diode. The light emitting diode may be included in a flip-chip light emitting diode. The light emitting diode may also be applied to a vertical light emitting diode.

The foregoing description concerns exemplary embodiments of the present invention and is intended to be illustrative and should not be construed as limiting the invention. The teachings therein may be readily applied to other types of devices. Many alternatives, modifications, and variations are within the scope and spirit of the present invention and will be apparent to those skilled in the art.

## Claims

1. A method of manufacturing a substrate for a high efficiency nitride-based light emitting diode on which a nano to micron sized pattern is formed, comprising:
a first step of forming a thin corrosion-proof resist film on one surface of a substrate or one surface of a nano mold;
a second step of positioning and pressing the substrate or the nano mold to face the thin corrosion-proof resist film and forming the thin corrosion-proof resist film having the nano to micron sized pattern on the substrate;
a third step of etching the substrate on which the nano to micron sized pattern is formed; and
a fourth step of annealing the etched substrate;
wherein:
the nano to micron sized pattern comprises a bottom section and a convex section, and a lower end diameter of the convex section is 0.1 to 3 times a light emitting wavelength of the light emitting diode;
the bottom section and the convex section of the nano to micron sized pattern are alternately formed, and a distance between a first convex section and a second convex section adjacent to the first convex section is 0.2 to 6 times the light emitting wavelength of the light emitting diode; and
the nano to micron sized pattern repeatedly comprises any one selected from the group consisting of a hemispherical shape, a triangular pyramidal shape, a quadrangular pyramidal shape, a hexagonal pyramidal shape, a conical shape, and a cut-spherical shape.

2. The method of manufacturing the substrate for the high efficiency nitride-based light emitting diode on which the nano to micron sized pattern is formed, according to claim 1, further comprising
a fifth step of further forming a buffer layer formed as a GaN layer on the annealed substrate after the fourth step, thereby improving a light extraction efficiency of the light emitting diode.

3. The method of manufacturing the substrate for the high efficiency nitride-based light emitting diode on which the nano to micron sized pattern is formed, according to claim 1, wherein the substrate is any one selected from the group consisting of a sapphire substrate, a silicon substrate, and a quartz substrate, and comprises any one selected from the group consisting of Al₂O₃, SiC, Si, SiO₂, quartz, AlN, GaN, Si₃N₄, and MgO.
